Europäisches Patentamt

European Patent Office

Office européen des brevets

(11) Publication number: **0 431 216 A1**

# EUROPEAN PATENT APPLICATION

(21) Application number: 89203093.3

(22) Date of filing: 06.12.89

(51) Int. Cl.5: **G01R 33/28**, G01R 33/38

(43) Date of publication of application:
12.06.91 Bulletin 91/24

(84) Designated Contracting States:
AT BE CH DE ES FR GB GR IT LI LU NL SE

(71) Applicant: N.V. Philips' Gloeilampenfabrieken
Groenewoudseweg 1
NL-5621 BA Eindhoven(NL)

(72) Inventor: Ham, Cornelis Leonardus Gerardus
c/o INT. OCTROOIBUREAU B.V. Prof.
Holstlaan 6
NL-5656 AA Eindhoven(NL)

(74) Representative: Scheele, Edial François et al
INTERNATIONAAL OCTROOIBUREAU B.V.
Prof. Holstlaan 6
NL-5656 AA Eindhoven(NL)

(54) Method for acoustical noise reduction in a magnetic resonance apparatus.

(57) In order to avoid acoustical noise in a magnetic resonance apparatus, frequency components in the gradient coil current spectrum causing acoustical noise are substantially reduced by optimizing the rise time of the gradient coil supply pulses.

# METHOD FOR ACOUSTICAL NOISE REDUCTION IN A MAGNETIC RESONANCE APPARATUS

The invention relates to a method for acoustical noise reduction in a magnetic resonance apparatus comprising a steady field main magnet and a gradient coil system.

Such a method is known from US 4,680,545 which discloses a method for acoustical noise reduction by adapting energizing pulses for the gradient coils in order to eliminate high-frequency components, for example beyond 1,5 kHz, in the frequency spectrum of said pulses. Edges of the energizing pulses are then no longer linear but become rounded, for example sinusoidal. Said method results in a varying steepness of the pulse edges, implying longer rise and fall times thereof. It is of more interest however, to have comparatively short rise and fall times. Furthermore, the known method does not affect acoustical noise frequencies well below the chosen value. Depending on the geometry and the construction of the magnetic resonance apparatus and the coil control, the noise proved to be due to one frequency component, or to some frequency components, or to a multitude of frequency components. Therefore the known method, cannot be universally applied.

It is an object of the invention to eliminate or at least mitigate the limitations of the known method; to this end, a method of the kind set forth in accordance with the invention is characterized in that in a gradient coil current amplitude spectrum, amplitudes which contribute to production of acoustical noise in the apparatus are substantially reduced.

Due to the fact that particularly those frequencies in the spectrum of the current through the gradient coil which strongly contribute to noise production in the apparatus are suppressed, the method according to the invention can deal with all acoustical noise frequencies and can be easily integrated in a gradient coil supply unit for any magnetic resonance apparatus.

A trapezoidal signal of a current having a rise and fall time S and a pulse duration defined as the half-width value D, has the following frequency spectrum:

$$F(f) \sim \frac{I}{\pi^2 f^2 S} . \sin(\pi S) . \sin(\pi D)$$

where I is the amplitude of the current and f is the frequency. This function exhibits many small peaks due to a repetition frequency of, for example 10 Hz, and dips, for example at approximately 120, 240, 360 and 480 Hz, and a pulse duration of approximately 8.25 ms, corresponding to the term $\sin(\pi D)$. The term $\sin(\pi S)$ is hardly present because the frequency of its first dip is about 1 kHz, corresponding to a rise time of 1 ms. The term $\sin(\pi S)$ becomes zero at about 300 Hz, corresponding to a rise time of 3.5 ms. The pulse duration D differs for various pulse sequences, but can also vary within a pulse sequence. The rise (and fall) time is usually constant within a pulse sequence and can be chosen for example in such a way that $\sin(\pi S)$ is zero at a particular frequency.

For a particular embodiment the dominant frequencies are 1,5 kHz for the Z-gradient coil and 0.6 kHz for the X-gradient coil. For the Z-gradient coil a group of peaks occurs in this embodiment but only a single peak for the X-gradient coil. When the rise time for the X and Y-gradient coils is chosen to be 1.55 ms, corresponding to a frequency of the peak of 0.64 kHz, a dip arises in the current spectrum which cancels the peak causing the acoustical noise. After cancellation of the dominant frequency of 0.64 kHz, the acoustical noise level becomes substantial lower. When the rise time deviates from the above optimum value, the acoustical noise level becomes substantially higher again. When a rise time of 1.55 ms is considered to be too long, the geometry of the apparatus can be modified in order to increase the dominant frequency from 0.64 kHz to, for example 1 kHz. In the latter case the optimum rise time is 1 ms. When the rise time for the Z-gradient coil is chosen to be 0.65 ms, corresponding to be a frequency peak of 1.5 kHz, the dip in the current spectrum will cancel the peak or peaks causing the acoustical noise. After cancellation of the dominant frequencies of 1.5 kHz, the acoustical noise level becomes much lower. When the rise time is chosen to be 1.3 ms, a second dip in the current spectrum will have a frequency of 1.5 kHz; application of such a pulse sequence again results in a substantial lower acoustic noise level.

Thus, a substantial acoustic noise reduction can be achieved by optimizing the rise time. For a Z-gradient coil the optimum rise time is a multiple of a given time interval, and for the X-gradient coil and the Y-gradient coil it is a multiple of a usually different time interval.

**Claims**

1. A method for acoustical noise reduction in a magnetic resonance apparatus comprising a steady field main magnet and a gradient coil system, characterized in that in a gradient coil current amplitude spectrum, amplitudes which contribute to production of acoustical noise in the apparatus are substantially reduced.

2. A method as claimed in Claim 1, characterized in that for a given geometry of the magnetic resonance apparatus and a trapezoidal gradient pulse (or pulses) the production of acoustical noise in the apparatus is reduced by optimizing the rise and fall times.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y,D | US-A-4 680 545 (F.L. GRAY et al.)<br>* Column 1, line 49 - column 2, line 26; column 5, lines 36-53; column 6, lines 18-28,62-65; figure 4A * | 1,2 | G 01 R 33/28<br>G 01 R 33/38 |
| Y | DE-A-3 808 995 (K.K. TOSHIBA)<br>* Abstract; column 4, line 58 - column 5, line 30; figures 3,5 * | 1,2 | |
| A | US-A-4 774 486 (K. MORITSU)<br>* Column 1, line 27 - column 2, line 8; figure 4 * | 1 | |
| A | EP-A-0 304 127 (N.V. PHILIPS' GLOEILAMPENFABRIEKEN)<br>* Column 1, line 7 - column 2, line 12 * | 1 | TECHNICAL FIELDS SEARCHED (Int. Cl.5)<br><br>G 01 N<br>G 01 R |

The present search report has been drawn up for all claims

| Place of search | Date of completion of the search | Examiner |
|---|---|---|
| THE HAGUE | 03-08-1990 | HORAK G.I. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P0401)